# EUROPÄISCHE PATENTANMELDUNG

(11) **EP 1 973 023 A1**
(43) Veröffentlichungstag der Anmeldung: **24.09.2008**
(21) Anmeldenummer: 08153109.7
(22) Anmeldetag: 20.03.2008
(51) Int. Cl.: G05D 23/00, H01M 2/30, H01M 8/04, H01M 10/48, H01M 10/50, H01M 6/50, H01M 8/02

(54) **Stromversorgungspack**

(30) Priorität: 23.03.2007 DE 102007014120
(71) Anmelder: Ferm B.V., 8028 PM Zwolle (NL)
(72) Erfinder: Woelders, Nils, Hongkou District shangai 200081 Shanghai (CN)
(74) Vertreter: Henkel, Feiler & Hänzel

(57) **Zusammenfassung**

Stramtrersorgungspack, mit einer oder mehreren galvanischen Zelle(n), die in einem Gehäuse (1) angeordnet ist/sind, einer Schaltungsanordnung (2) mit zumindest einem elektronischen Bauteil (3), das im Betrieb Wärme erzeugt und zu kühlen ist, und einem Kontaktanschluss (4) des Batteriepacks. Das zumindest eine elektronische Bauteil (3) ist wärmeleitend mit dem Kontaktanschluss (4) verbunden, wodurch ein separates Kühlelement entfallen kann und die Montage vereinfacht ist.

## Beschreibung

Die Erfindung betrifft einen Stromversorgungspack, mit einer oder mehreren galvanischen Zelle(n), die in einem Gehäuse (1) angeordnet ist/sind. Der Stromversorgungspack dient insbesondere als Stromquelle für mobile elektrische Hand-Werkzeugmaschinen wie Hand-Bohrmaschinen, Hand-Sägen, Hand-Schleifmaschinen usw., ist aber in Verbindung mit allen Arten von elektrischen Geräten einsetzbar, die eine mobile elektrische Stromversorgung benötigen.

Als Stromspeicher bzw. Energiewandler in dem erfindungsgemäßen Stromversorgungspack werden eine oder mehrere galvanische Zelle(n) in der Form von Sekundärzelle(n) bzw. Akkumulatoren oder eine Brennstoffzelle (mit einem zusätzlichen Brennstoffspeicher) verwendet. Solche Stromspeicher bzw. Energiewandler sind an sich bekannt. Im Bereich der mobilen elektrischen Werkzeugmaschinen werden beispielsweise häufig Li-Ionen-Akkumulatoren eingesetzt. Die Stromversorgungspacks besitzen üblicherweise zwei Kontaktanschlüsse, die aus dem jeweiligen Gehäuse herausgeführt sind und an denen die Energie des Stromversorgungspacks abgegriffen wird und diese entweder fest mit dem jeweiligen Gerät verdrahtet sind oder die mit entsprechenden Gegenkontakten des jeweiligen Geräts lösbar in Kontakt gebracht werden, sofern ein leichter Austausch des Stromversorgungspacks gewünscht ist.

Bei derartigen Stromversorgungspacks ist im Gehäuse üblicherweise eine Schaltungsanordnung zur Stabilisierung der Stromversorgung, für Ladezwecke und/oder als Sicherungsschaltung oder für andere Funktionen vorgesehen, die elektronische Leistungs-Bauteile aufweisen, die im Betrieb Wärme erzeugen und gekühlt werden müssen.

Bisher werden hierfür separate Kühlelemente wie Kühlbleche oder Heat-Pipes verwendet, die aber den Montageaufwand und die Kosten erhöhen.

Aufgabe der Erfindung ist die Vereinfachung des Aufbaus und der Montage derartiger Stromversorgungspacks.

Zur Lösung bringt die Erfindung einen Stromversorgungspack mit den Merkmalen des Patentanspruches 1 in Vorschlag. Bevorzugte Ausgestaltungen sind in den abhängigen Ansprüchen angegeben.

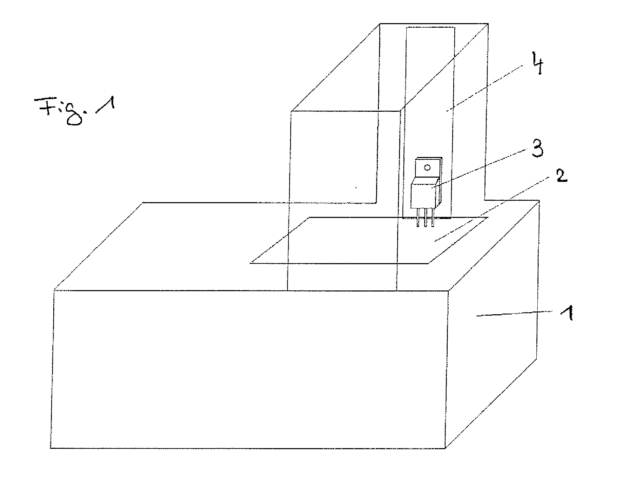

Im folgenden wird die Erfindung anhand der beigefügten Zeichnung erläutert, die schematisch den Aufbau eines erfindungsgemäßen Stromversorgungspacks zeigt.

Der erfindungsgemäße Stromversorgungspack besitzt, wie im eingangs dargelegten Stand der Technik bekannt, im Inneren eines Gehäuses 1 angeordnete Stromspeicher bzw. Energiewandler mit einer oder mehreren galvanischen Zelle(n) sowie eine Schaltungsanordnung 2 mit zumindest einem elektronischen Bauteil 3, das im Betrieb Wärme erzeugt, und das zu kühlen ist. Typische Beispiele für derartige elektronische Bauteile sind elektrische Leistungs-Schaltelemente, beispielsweise Transistoren wie Feldeffekttransistoren (FET), die die Stromversorgung bei Strom-Überlast, bei Unterspannung oder thermischer Überlast oder anderen unerwünschten Zuständen abschalten. Auch andere elektrische Bauteile wie Thyristoren, Widerstände oder Dioden können zu kühlen sein.

Diese Bauteile der Schaltungsanordnung sind üblicherweise auf einer Platine 2 angeordnet, die sich im Inneren des Gehäuses 1 befindet, oder sind mit einer solchen Platine elektrisch leitend verbunden.

Bei dem erfindungsgemäßen Stromversorgungspack ist/sind ein oder mehrere Kontaktanschluss/Kontaktanschlüsse 4 (üblicherweise 2, wobei einer als + und einer als - Pol dient) des Batteriepacks aus dem Gehäuse herausgeführt. Der bzw. die Kontaktanschluss/Kontaktanschlüsse 4 des Batteriepacks ist/sind als ein Blechstreifen, vorzugsweise aus Metall ausgebildet.

Erfindungsgemäß ist/sind eines oder mehrere der zu kühlenden elektronischen Bauteile 3 der Schaltungsanordnung im Inneren des Gehäuses wärmeleitend mit einem der Kontaktanschlüsse 4 verbunden. Die Verbindung kann durch unmittelbaren Kontakt oder durch Zwischenfügung einer thermisch leitenden Schicht sowie durch eine mechanische Verbindung wie eine Niet-, eine Schraub-, eine Klemm-, eine Klebe- oder eine Steckverbindung oder durch Kombinationen dieser Verbindungsarten hergestellt sein. Andere Verbindungsarten sind möglich, sofern der thermische Übergang gewährleistet ist. Eine elektrisch leitende Verbindung ist hierbei nicht vorgesehen. Vorzugsweise kann zur Gewährleistung einer elektrischen Trennung eine zusätzliche Isolierschicht vorgesehen sein, die aber den Wärmeübergang nicht oder zumindest nicht wesentlich beeinträchtigt.

Die thermisch leitende Verbindung zwischen dem Bauteil und dem Kontaktanschluss des Stromversorgungspacks ermöglicht eine einfache Kühlung des Bauteils ohne dass ein separates Kühlmittel oder -element hierfür erforderlich ist. Der Kontaktanschluss besitzt eine vergleichsweise gute Leitfähigkeit und eine relativ große Abstrahlfläche, insbesondere wenn er als Blechstreifen ausgeführt ist. Der Kontaktanschluss erstreckt sich üblicherweise nicht nur im Gehäuse sondern auch zur Außenseite, so dass ein guter Wärmetransport auch durch Leitung der Wärme nach Außen und Konvektion an der Außenseite gewährleistet ist.

Ist eine größere Wärmeabstrahlung erforderlich kann der Kontaktanschluss, insbesondere als Blechstreifen, insgesamt oder abschnittsweise breiter gestaltet werden, was fertigungstechnisch einfach ist und die Kosten kaum beeinflusst. Außerdem wird bei einer Verbreiterung des Kontaktanschlusses auch eine elektrisch leitende Verbindung mit großem Querschnitt und damit niedrigem Widerstand erreicht, was insbesondere bei leistungsstarken Hand-Werkzeugmaschinen von Vorteil ist.

Die direkte Verbindung zwischen dem Kontaktanschluss und dem zu kühlenden elektronische Bauteil vereinfacht ferner die Montage, weil jedenfalls ein weiteres Bauteil, nämlich das separate Kühlelement für das oder die elektronische(n) Bauteile entfällt. Ferner kann die gesamte Einheit aus Platine, zu kühlenden Bauteil(en) und Kontaktanschluss/Kontaktanschlüssen vorgefertigt und als Baugruppe in das Gehäuse eingebaut werden.

Um den Wärmeabtransport von dem Kontaktanschluss zu erhöhen kann dieser zumindest in einem Abschnitt mit Mitteln zur Vergrößerung der Wärmeabstrahlung und -konvektion, beispielsweise mit Kühlfahnen oder -rippen versehen sein. Diese Mittel können als separate Bauteile mit dem Kontaktanschluss verbunden sein oder aber integral mit diesem, beispielsweise durch angeformte und abgebogene Blechfahnen gebildet sein.

Selbst wenn mehrere Kontaktanschlüsse vorgesehen sind, ist es unter Umständen ausreichend, wenn nur einer davon so ausgestaltet ist, dass er mit dem oder den zu kühlenden Bauteil(en) thermisch leitend verbunden ist. Die Kontaktanschlüsse eines Stromversorgungspack können daher auch unterschiedlich ausgestaltet sein.

## Patentansprüche

1. Stromversorgungspack, mit
einer oder mehreren galvanischen Zelle(n), die in einem Gehäuse (1) angeordnet ist/sind,
einer Schaltungsanordnung (2) mit zumindest einem elektronischen Bauteil (3), das im Betrieb Wärme erzeugt, und
einem Kontaktanschluss (4) des Batteriepacks,
**dadurch gekennzeichnet, dass**
das zumindest eine elektronische Bauteil (3) wärmeleitend mit dem Kontaktanschluss (4) verbunden ist.

2. Der Stromversorgungspack nach Anspruch 1, wobei der Kontaktanschluss (4) des Batteriepacks ein Blechstreifen, vorzugsweise aus Metall ist.

3. Der Stromversorgungspack nach Anspruch 1 oder 2, wobei das elektronische Bauteil (3) mit dem Kontaktanschluss durch eine Niet-, eine Schraub-, eine Klemm-, eine Klebe- oder eine Steckverbindung oder durch eine Kombination davon wärmeleitend verbunden ist.

4. Der Stromversorgungspack nach einem der Ansprüche 1 bis 3, wobei das elektronische Bauteil ein elektrisches Schaltelement (3), beispielsweise ein Transistor, insbesondere ein Feldeffekttransistor (FET), ein Thyristor, ein Widerstand oder eine Diode ist.

5. Der Stromversorgungspack nach einem der Ansprüche 1 bis 4, wobei der Kontaktanschluss (4) des Batteriepacks aus dem Gehäuse herausgeführt ist und das elektronische Bauteil (3) im Inneren des Gehäuses mit dem Kontaktanschluss (4) verbunden ist.

6. Der Stromversorgungspack nach einem der Ansprüche 1 bis 5, wobei die Schaltungsanordnung auf einer Platine (2) angeordnet ist, die sich im Inneren des Gehäuses befindet, und das elektronische Bauteil mit der Schaltungsanordnung verbunden ist.

7. Der Stromversorgungspack nach einem der Ansprüche 1 bis 6, wobei der Kontaktanschluss (4) zumindest in einem Abschnitt mit Mitteln zur Vergrößerung der Wärmeabstrahlung, beispielsweise mit Kühlfahnen oder -rippen versehen ist.

8. Der Stromversorgungspack nach einem der Ansprüche 1 bis 7, wobei die galvanische(n) Zelle(n) eine Sekundärzelle(n) oder eine Brennstoffzelle ist/sind.
